# EUROPEAN PATENT APPLICATION

(11) **EP 3 620 289 A1**
(43) Date of publication of application: **11.03.2020**
(21) Application number: 19154782.7
(22) Date of filing: 31.01.2019
(51) Int. Cl.: B29C 64/124, B29C 64/20, B29C 64/321, B33Y 10/00, B33Y 30/00

(54) **METHOD OF MAKING SURFACES SMOOTH OR FLAT FOR 3D PRINTING**

(30) Priority: 04.09.2018 CN 201811025176
(71) Applicant: XYZprinting, Inc., New Taipei City 22201 (TW); Kinpo Electronics, Inc., New Taipei City 22201 (TW)
(72) Inventor: CHOU, Ching-Yuan, 22201 New Taipei City (TW)
(74) Representative: 2K Patentanwälte Blasberg Kewitz & Reichel

(57) **Abstract**

A method of making surfaces smooth or flat for 3D printing applied to a stereolithography 3D printer (2) is provided. The method is to control a modeling plane of a curing platform (24) to contact light-curable materials (41) in a material tank (23), moving the modeling tank (23) by a moving module (22) for making the light-curable materials (41) in the modeling tank (23) flow, and control a light module (21) to irradiate the curing platform (24) according to print data for manufacturing one layer of slice physical model on the modeling plane. The method can effectively reduce the defects on the surface of a physical model, and improve a printing quality of the physical models.

## Description

### BACKGROUND OF THE INVENTION

### Field of the Invention

The technical field relates to 3D printing and more particularly related to a method of making surfaces smooth or flat for 3D printing.

### Description of Related Art

A stereolithography 3D printer of the related art has an ability to cure the light-curable materials into a 3D physical model by light-irradiating. More specifically, the stereolithography 3D printer comprises a curing platform, a material tank, and a light module. The material tank is used to accommodate the fluid light-curable materials, and a tenacity film is laid on the bottom of the material tank. A surface of above-mentioned tenacity film is very smooth, so as to make the cured light-curable materials (namely 3D physical model) do not stick to the tenacity film and prevent the printing from failure.

However, a deformation may occur on the tenacity film when the tenacity film is pressed by a force. For example, when the curing platform submerge into the light-curable materials, the light-curable materials transfer a downforce of the curing platform to the tenacity film, such that the deformation (such as depression or gap) may occur on a surface of the tenacity film temporarily. Above-mentioned status may make a defect (such as depression or gap) be generated on the surface of the cured light-curable materials (namely 3D physical model), such that a printing quality of the 3D physical model is lowered.

Thus, the stereolithography 3D printing technology has above-mentioned problems, there is a need for a more effective solution.

### SUMMARY OF THE INVENTION

The present disclosed example is directed to a method of making surfaces smooth or flat for 3D printing, the method has an ability of reducing or eliminating the deformation generated on the tenacity film.

One of the exemplary embodiments, a method of making surfaces smooth or flat for 3D printing applied to a stereolithography 3D printer, the stereolithography 3D printer comprises a light module, a curing platform, a material tank and a moving module, a tenacity film is laid on bottom of the material tank, the method of making surfaces smooth or flat for 3D printing comprises following steps: making a modeling plane of the curing platform contact with light-curable materials in the material tank; controlling the moving module to start to move the material tank for making the light-curable materials between the curing platform and the tenacity film flow; and, stopping moving the material tank and controlling the light module to irradiate light to the curing platform for printing one layer of slice physical model on the modeling plane.

The present disclosed example can effectively reduce the defects on the surface of a physical model, and improve a printing quality of the physical models.

### BRIEF DESCRIPTION OF DRAWING

The features of the present disclosed example believed to be novel are set forth with particularity in the appended claims. The present disclosed example itself, however, may be best understood by reference to the following detailed description of the present disclosed example, which describes an exemplary embodiment of the present disclosed example, taken in conjunction with the accompanying drawings, in which:
Fig. 1A is a first schematic view of stereolithography 3D printing of the related art;
Fig. 1B is a second schematic view of stereolithography 3D printing of the related art;
Fig. 1C is a third schematic view of stereolithography 3D printing of the related art;
Fig. 2 is an architecture diagram of a stereolithography 3D printer according to one embodiment of the present disclosed example;
Fig. 3A is a look-down schematic view of moving material tank according to one embodiment of the present disclosed example;
Fig. 3B is a look-down schematic view of moving material tank according to another embodiment of the present disclosed example;
Fig. 4A is a first schematic view of stereolithography 3D printing according to one embodiment of the present disclosed example;
Fig. 4B is a second schematic view of stereolithography 3D printing according to one embodiment of the present disclosed example;
Fig. 4C is a third schematic view of stereolithography 3D printing according to one embodiment of the present disclosed example;
Fig. 4D is a forth schematic view of stereolithography 3D printing according to one embodiment of the present disclosed example;
Fig. 5 is a schematic view of appearance of a 3D printer according to one embodiment of the present disclosed example;
Fig. 6 is a flowchart of a method of making surfaces smooth or flat for 3D printing according to a first embodiment of the present disclosed example; and
Fig. 7 is a flowchart of a method of making surfaces smooth or flat for 3D printing according to a second embodiment of the present disclosed example.

### DETAILED DESCRIPTION OF THE INVENTION

In cooperation with attached drawings, the technical contents and detailed description of the present disclosed example are described thereinafter according to some exemplary embodiments, being not used to limit its executing scope. Any equivalent variation and modification made according to appended claims is all covered by the claims claimed by the present disclosed example.

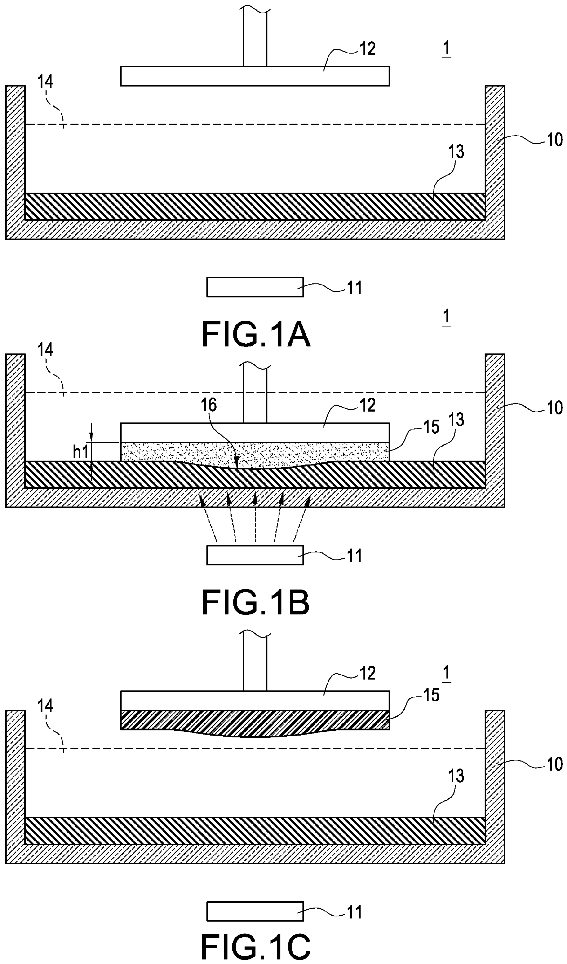

Please refer to Fig. 1A to Fig. 1C simultaneously, Fig. 1A is a first schematic view of stereolithography 3D printing of the related art, Fig. 1B is a second schematic view of stereolithography 3D printing of the related art and Fig. 1C is a third schematic view of stereolithography 3D printing of the related art. Fig. 1A to Fig. 1C are used to exemplary explain the technical problems solved by the present disclosed example.

As shown in Fig. 1A, in general, the stereolithography 3D printer 1 of the related art (take uplight stereolithography 3D printer for example) comprises a material tank 10, a light module 11 and a curing platform 12. The material tank 10 is used to accommodate the fluid light-curable materials 14, and a tenacity film 13 is laid on the bottom of the material tank 10.

As shown in Fig. 1B, the stereolithography 3D printer 1 may control the curing platform 12 to lower for contacting with the light-curable materials 14, and make a worktop of the curing platform 12 be a default thickness h1 away from the tenacity film 13.

Please be noted that when the modeling plane contacts with the light-curable materials 41, a downforce caused by lowing the curing platform 12 may be transferred to the tenacity film 13, such that a deformation may occur on the tenacity film 13, such as a deformation area 16. Furthermore, in general, the light-curable materials 14 have poor fluidity (namely a speed of flow and deformation of an object when it is pressed by an external force). Once a lowering time of the curing platform 12 is less than a flowing time of the light-curable materials14 (namely a time required for the light-curable materials 14 flowing from an area covered with the curing platform 12 to an area uncovered with the curing platform 12), the light-curable materials 14 pressed by the downforce have not enough time to spread around via naturally flowing (namely, there is not enough time to disperse the downforce to whole tenacity film 13), and directly compress a specific area of the tenacity film 13 (such as the area covered with the curing platform 12). Above-mentioned status causes a deformation on the tenacity film 13.

Then, the stereolithography 3D printer 1 controls the light module 11 to irradiate light to the light-curable materials 14 between the curing platform 12 and the tenacity film 13 for making the stereolithography materials 14 solidify into the first layer of slice physical model 15. Moreover, the light-curable materials 14 in the deformation area 16 of the tenacity film 13 will be a defect (take a protrusion for example in Figures) on the slice physical model 15 after irradiation, such that a printing quality of the physical models declines.

Then, as shown in Fig. 1C, the stereolithography 3D printer 1 controls the curing platform 12 to rise to make the first layer of the printed slice physical model leave from the light-curable materials 14 for completion of printing one layer of the slice physical model 15.

Then, the stereolithography 3D printer 1 may make a surface of the first layer of slice physical model 15 be the default thickness h1 away from the tenacity film 13, and irradiate light to the light-curable materials 14 for printing the second layer of slice physical model. The stereolithography 3D printer 1 can manufacture a 3D physical model stacked by the multiple layers of slice physical models via repeating above-mentioned steps.

The stereolithography 3D printing technology of the related art has poor printing quality because each layer of the printed slice physical model has the defect and the 3D physical model stacked by the multiple layers of the printed slice physical models has the corresponding defect.

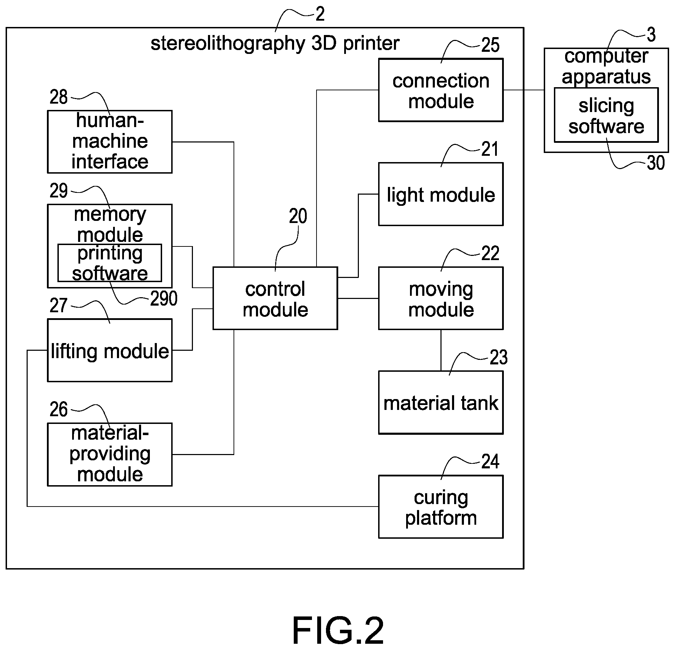

Please refer to Fig. 2, which is an architecture diagram of a stereolithography 3D printer according to one embodiment of the present disclosed example. As shown in the Figure, a stereolithography 3D printer 2 is disclosed by this embodiment.

The stereolithography 3D printer 2 mainly comprises a light module 21, a moving module 22, a material tank 23, a curing platform 24 and a control module 20 electrically connected to above devices.

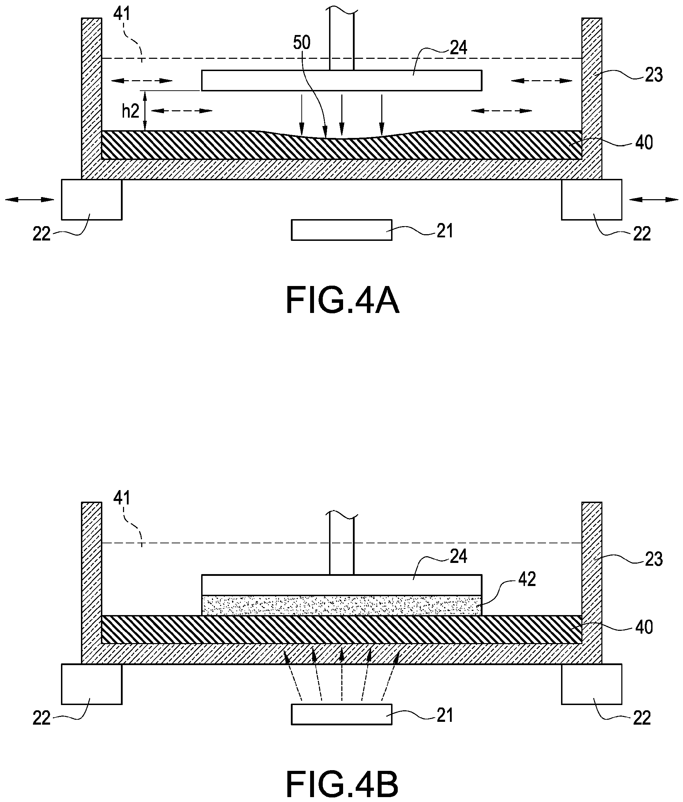

The control module 20 is conFigured to control the stereolithography 3D printer 2 to execute the stereolithography 3D printing. The light module 21 is conFigured to emit the beams heading to the curing platform 24 (the light module 21 may be a single point light source, a line light source or a plane light source). The beams are irradiated to one or more designated print position(s) between the material tank 23 and the curing platform 24 for curing the light-curable materials (such as the print positions shown in Fig. 4A to Fig. 4D, namely the light-curable materials 41 between the curing platform 24 and the tenacity film 40) in the light path.

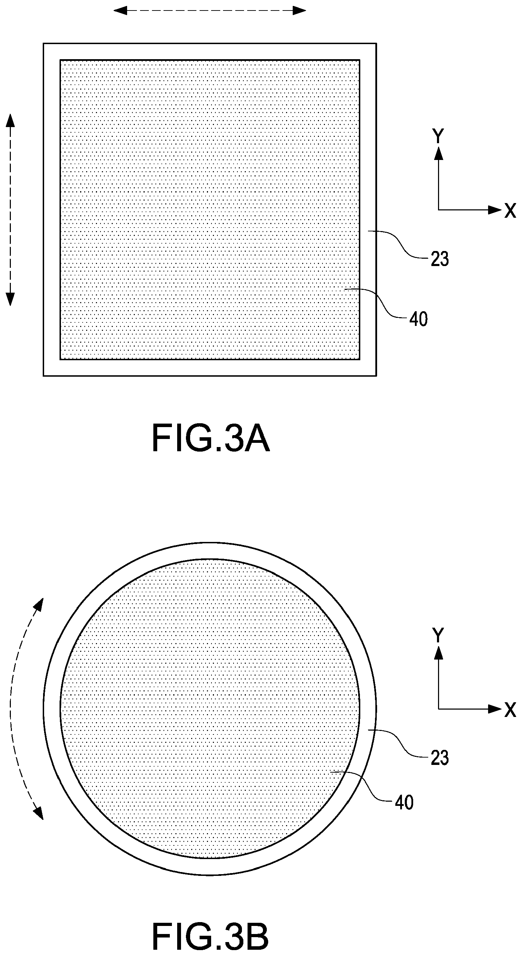

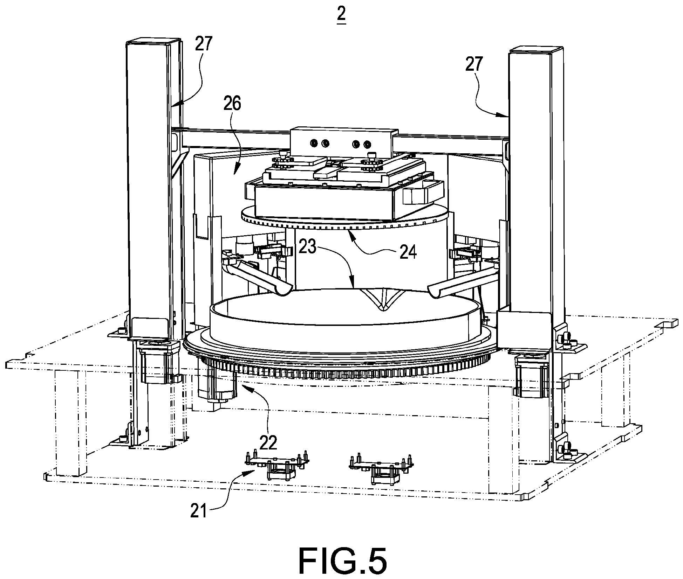

The material tank 23 is used to accommodate the fluid light-curable materials 41, such as UV curable resin. One of the exemplary embodiments, when the stereolithography 3D printer 2 is an uplight stereolithography 3D printer (as shown in Fig. 5), a bottom case of the material tank 23 may be made from the light-transmissive material, and one layer of light-transmissive tenacity film (such as the tenacity film 40 shown in Fig.3A and 3B, the tenacity film 40 may be made from light-transmissive silicone) is laid on the bottom inside the tank. Thus, the beams emitted by the light module 21 may transmit through the bottom case of the material tank 23 and the tenacity film 40 to irradiate light to the light-curable materials 41 in the material tank 23.

The moving module 22 is connected to the material tank 23, and is configured to be controlled to move (such as horizontal movement, rotation or a combination of horizontal movement and rotation) the material tank 23 by the control module 20 for making the light-curable materials 41 accommodated in the material tank 23 flow caused by moving the material tank 23. The print platform 24 is used to carry the manufactured 3D physical model.

Please refer to Fig. 3A, which is a look-down schematic view of moving material tank according to one embodiment of the present disclosed example. As shown in the Figure, in this example, a shape of the material tank 23 is square (the shape of the material tank 23 can be changed to other shapes), and a tenacity film 40 is laid on a bottom of the material tank 23. Moreover, the moving module 22 horizontally moves the material tank 23 back and forth in the horizontal direction (such as any direction in the X-Y plane). For example, moving the material tank 23 back and forth along the X axis.

Please refer to Fig. 3B, which is a look-down schematic view of moving material tank according to another embodiment of the present disclosed example. As shown in the Figure, in this example, the shape of the material tank 23 is circular (the shape of the material tank 23 can be changed to other shapes), and the tenacity film 40 is laid on the bottom of the material tank 23. Moreover, the moving module 22 horizontally rotates the material tank 23 (such as horizontally rotating in the X-Y plane). For example, rotating 180 degrees clockwise, rotating 180 degrees anti-clockwise or a combination of rotating clockwise and anti-clockwise.

Please be noted that although the material tank 23 which its shape is non-circular (such as being square, rectangle or regular hexagon) has the advantages of easy to make, big printable area and so forth, the non-circular material tank 23 is not suitable for the moving means of rotation because rotating the non-circular material tank 23 needs larger space. Thus, the present disclosed example can drastically save the space required by rotation via using the moving means of horizontally moving back and forth on the non-circular material tank 23.

Moreover, for the circular molding groove 23, the present disclosed example can achieve the following advantages via using the moving means of horizontally rotating: it being not necessary to additionally plan a moving space for the material tank 23 (by situ rotation); and it being easy to adjust a flow speed of the light-curable materials 41 (by adjusting the rotating speed of the material tank 23).

Please refer to Fig. 2, one of the exemplary embodiments, the stereolithography 3D printer 2 further comprises a connection module 25 electrically connected to the control module 20, such as USB module, PCI bus module, Wi-Fi module or Bluetooth module. The connection module 25 is configured to connect to the computer apparatus 3 and receive the print data from the computer apparatus3. One of the exemplary embodiments, the computer apparatus 3 stores a slicing software 30, the computer apparatus 3 may execute the slicing software 30 to execute a slicing process on the 3D model data for obtaining the multiple layers of print data (such as a plurality of 2D images), and transfer the print data to the connection module 25 for 3D printing.

One of the exemplary embodiments, the stereolithography 3D printer 2 further comprises a material-providing module 26 electrically connected to the control module 20. The material-providing module 26 accommodates the fluid light-curable materials 41 and has an ability of pouring the designated volume of light-curable materials 41 (with designated flow rate) into the material tank 23.

One of the exemplary embodiments, the stereolithography 3D printer 3 further comprises a lifting module 27 electrically connected to the control module 20 and connected to the curing platform 24. The lifting module 27 may be controlled by the control module 20 to move the curing platform 24 along a default axis (such as lifting in the Z axis).

One of the exemplary embodiments, the stereolithography 3D printer 2 further comprises a human-machine interface 28 (such as buttons, a monitor, indicators, a buzzer, or any combination of above elements) electrically connected to the control module 20. The human-machine interface 28 is configured to receive a user operation and output the print-related information.

One of the exemplary embodiments, the stereolithography 3D printer 2 further comprises a memory module 29 electrically connected to the control module 20. The memory module 29 is used to store data.

One of the exemplary embodiments, the memory module 29 comprises a non-transient computer-readable recording media, above non-transient computer-readable recording media stores a printing software 290 (such as a firmware or an operating system of the stereolithography 3D printer 2), and a plurality of computer-executable codes are recorded in the printing software 290. The control module 20 may perform each step of the method of making surfaces smooth or flat for 3D printing of each embodiment of the present disclosed example after execution of the printing software 290.

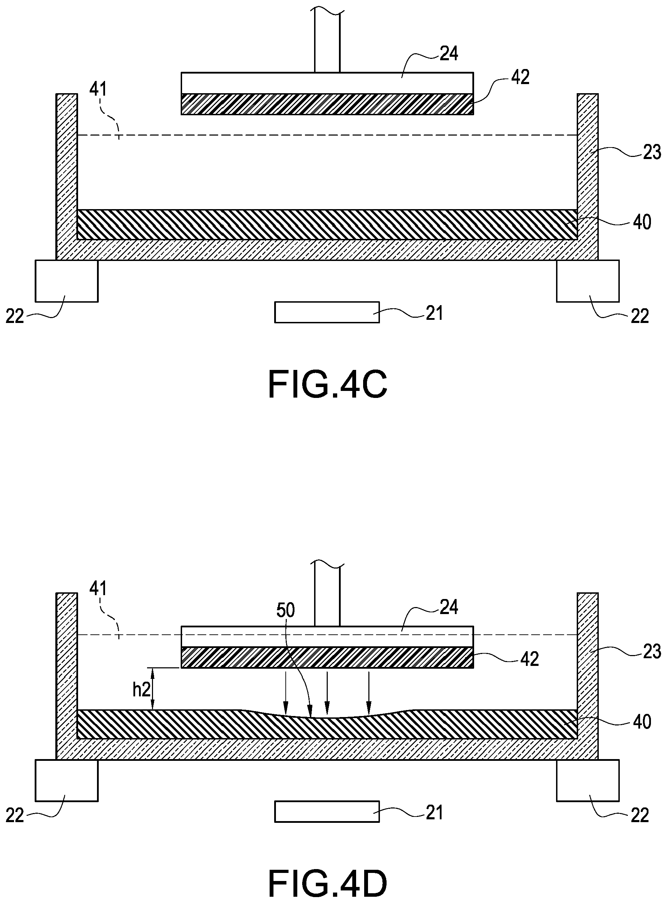

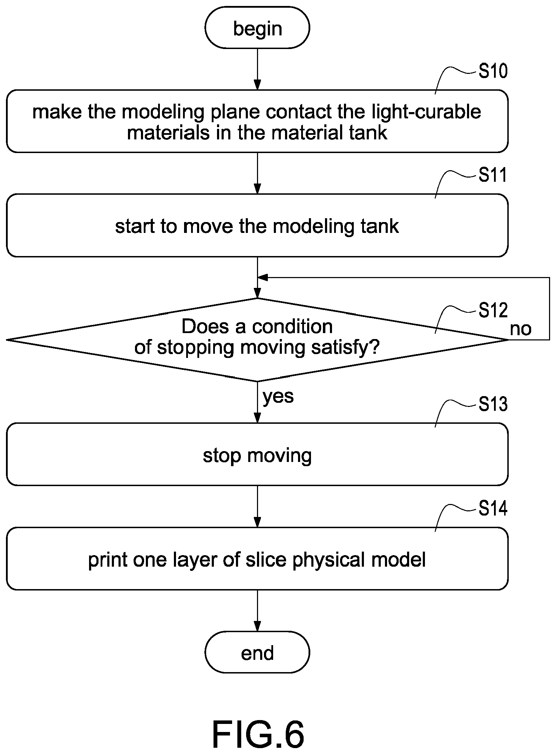

Please refer to Fig. 4A to Fig. 6, Fig. 4A is a first schematic view of stereolithography 3D printing according to one embodiment of the present disclosed example, Fig. 4B is a second schematic view of stereolithography 3D printing according to one embodiment of the present disclosed example, Fig. 4C is a third schematic view of stereolithography 3D printing according to one embodiment of the present disclosed example, Fig. 4D is a forth schematic view of stereolithography 3D printing according to one embodiment of the present disclosed example, Fig. 5 is a schematic view of appearance of a 3D printer according to one embodiment of the present disclosed example and Fig. 6 is a flowchart of a method of making surfaces smooth or flat for 3D printing according to a first embodiment of the present disclosed example.

The stereolithography 3D printer 2 shown in Fig. 4A to Fig. 4D is configured to move the material tank 23 by moving horizontally. The stereolithography 3D printer 2 shown in Fig. 5 is configured to move the material tank 23 by rotating.

The method of making surfaces smooth or flat for 3D printing of each embodiment of the present disclosed example may be implemented by the stereolithography 3D printer 2 shown in Fig. 2 to Fig. 5. The following description takes the moving means being moving horizontally as shown in Fig. 4A to Fig. 4D for explaining. The method of making surfaces smooth or flat for 3D printing of this embodiment comprises following steps.

Step S10: the control module 20 of the stereolithography 3D printer 2 makes a modeling plane of the curing platform 24 contact with light-curable materials 41 in the material tank 23.

More specifically, as shown in Fig. 4, the control module 20 controls the lifting module 27 to move the curing platform 24 to make all or part of the modeling plane (such as the worktop of the curing platform 24) submerge into the light-curable materials 41 from a position upon the liquid level of the light-curable materials 41 and make the modeling plane be a default thickness h2 (such as 0.3 centimeters) away from a bottom of the material tank 23.

Moreover, when the modeling plane of the curing platform 24 starts to submerge into the light-curable materials 41, the modeling plane may apply a downforce to the tenacity film 40 though the light-curable materials 41, such that a deformation is generated on the tenacity film 40 (such as the deformation area 50).

Please be noted that above-mentioned modeling plane may be the worktop of the curing platform 24 if there is not any layer of printed slice physical model 42. Above-mentioned modeling plane may be the surface of the top layer of printed slice physical models 42 if there is at least one layer of printed slice physical model 42 (for example, if three layers of slice physical models are printed, the modeling plane may be the top surface of the third layer of slice physical model 42). More specifically, the multiple layers of slice physical models 42 are stacked layer by layer during 3D printing, only the top layer of the slice physical models 42 (if it exists) is necessary to contact the light-curable materials 41 for printing the next layer of slice physical model. It is not necessary to make the whole curing platform 24 submerge into the light-curable materials 41.

One of the exemplary embodiments, in the step S10, the control module 20 is performed to adjust a distance between the worktop of the curing platform 24 and the tenacity film 40 according to a number of layers of printed slice physical models 42. For example, if there is not any layer of printed slice physical model 42, the worktop of the curing platform 24 is the default thickness away from the tenacity film 40. If there is one layer of printed slice physical model 42, the worktop of the curing platform 24 is double of default thickness away from the tenacity film 40. If there is two layers of printed slice physical models 42, the worktop of the curing platform 24 is triple of default thickness away from the tenacity film 40, and so forth.

Step S11: the control module 20 controls the moving module 22 to start to move the material tank 23 for making the light-curable materials 41 between the curing platform 24 and the tenacity film 40 flow. Thus, the downforce which made the deformation area 50 of the tenacity film 40 will be released by flow, and the tenacity film 40 reverts to become horizontal (namely, the deformation area 5 becomes smooth or flat or disappears).

As shown in Fig. 4A, the control module 20 may control the moving module 22 to move the material tank 23 in a horizontal direction for releasing the downforce.

Step S12: the control module 20 determines whether a condition of stopping moving satisfies. More specifically, above-mentioned condition of stopping moving is configured by a user or a developer in advance and stored in the memory module 29.

One of the exemplary embodiments, the condition of stopping moving may be at least one of moving a default times (such as moving back and forth for 3 times), moving for a default time (such as 3 seconds) or rotating a default angle (such as rotating 180 degrees if the moving means is rotation).

If the condition of stopping moving satisfies, the control module 20 performs the step S13. Otherwise, the control module 20 continues to control the moving module 22 to move the material tank 23, and determines whether the condition of stopping moving satisfies continuously.

Step S13: the control module 20 controls the moving module 22 to stop moving the material tank 23.

One of the exemplary embodiments, the control module 20 may time and wait for a default wait time (such as 3 seconds) for making the flowing light-curable materials 41 revert to be static and prevent from print failure.

Step S14: the control module 20 controls the light module 21 to irradiate light to the curing platform 24 according to one of the multiple layers of print data (such as the first layer of print data) for curing the light-curable materials 41 in the light path and printing one layer of slice physical model 42 on the modeling plane (as shown in Fig. 4B).

One of the exemplary embodiments, each layer of the print data is a 2D image, the control module 20 may control the light module 21 irradiate light to a plurality of positions respectively corresponding to a plurality of pixels of one layer of print data according to a plurality of pixel values of the pixels of one layer of print data for printing one layer of slice physical model 42.

The present disclosed example can effectively reduce the defects on the surface of a physical model, and improve a printing quality of the physical models.

The present disclosed example can significantly reduce the deformation of the tenacity film via making the light-curable materials between the curing platform and the tenacity film flow to distribute the downforce on the tenacity film, and significantly reduce the gaps on the surface of the printed slice physical models.

Please be noted that the control module 20 may control the curing platform 24 to lift up for making the modeling plane leave from the light-curable materials 41 (as shown in Fig. 4C) after completion of one layer of the slice physical mode 42). Moreover, the control module 20 may further wait for a default time (such as 3 seconds) for making the light-curable materials 41 backfill a space occupied by the modeling plane previously via flowing and making the liquid level revert to be horizontal.

Then, the control module 20 may perform the step S10 to the step 14 again for printing the next layer of slice physical model 42. More specifically, the control module 20 may make the modeling plane (as shown in Fig. 4D) of the curing platform 24 submerge into the light-curable materials 41, and make the modeling plane be the default thickness h2 away from the tenacity film 40. At this time, the deformation may be generated on the tenacity film 40 (such as the deformation area 50 shown in Fig.4D). Then, the control module 20 moves the material tank 23 until the condition of stopping moving satisfies, and prints the next layer of slice physical model 42 on the modeling plane according to the next layer of print data (such as the second layer of print data).

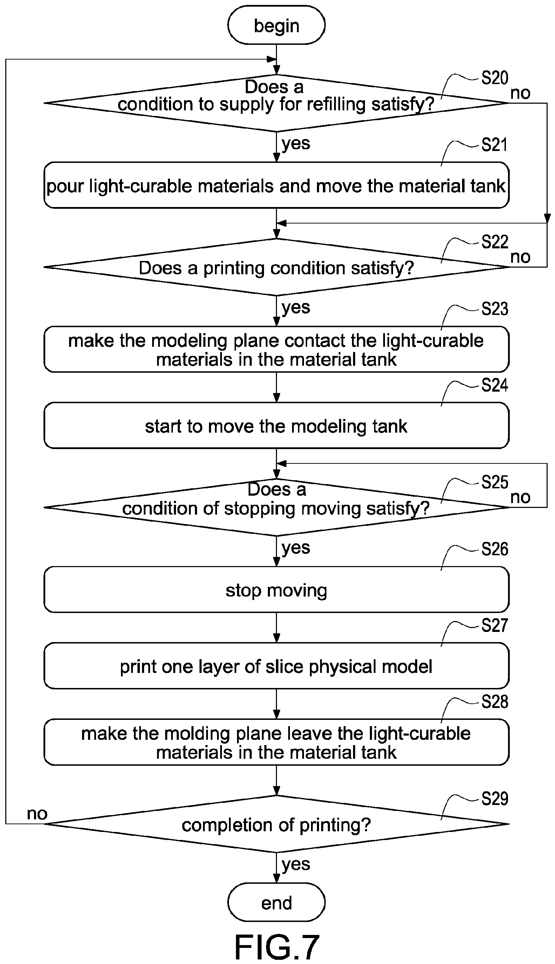

Please refer to Fig. 7 simultaneously, Fig.7 is a flowchart of a method of making surfaces smooth or flat for 3D printing according to a second embodiment of the present disclosed example. This embodiment uses the moving means that rotation as shown in Fig. 3B, but this specific example is not intended to limit the scope of the present disclosed example. The moving means may be replaced with horizontal movement as shown in Fig. 3A and Fig. 4A in the other embodiment. Moreover, this embodiment takes the stereolithography 3D printer 2 of Fig. 2 and Fig. 5 for explain. More specifically, after reception of a 3D printing instruction (such as receiving the printing data and the 3D printing instruction from the computer apparatus 3), the stereolithography 3D printer 2 may perform following steps for manufacturing a 3D physical model corresponding to above-mentioned print data.

Step S20: the control module 20 of the stereolithography 3D printer 2 determines whether a default condition to supply for refilling satisfies. More specifically, above-mentioned condition to supply for refilling is configured by a user or a developer in advance and stored in the memory module 29.

One of the exemplary embodiments, the condition to supply for refilling may be any combination of following conditions: the time before printing the first layer of slice physical model 42; each time the designated layers (such as 10 layers) of slice physical models 42 being printed; each time the designated volume of slice physical models 42 being printed; and the liquid level of the light-curable materials 41 in the material tank 23 is lower than a default height.

If the condition to supply for refilling satisfies, the control module 20 performs the step S21. Otherwise, the control module 20 performs the step S22.

Step S21: the control module 20 controls the material-providing module 26 to pour the new light-curable materials 41 into the material tank 23.

One of the exemplary embodiments, the material-providing module 26 pours the stored light-curable materials 41 into the material tank 23 by a transportation pipe (as shown in Fig. 5).

One of the exemplary embodiments, during the material-providing module 26 pouring the light-curable materials 41, the control module 20 may control the moving module 22 to rotate the material tank 23 with a second speed (such as 720 degrees per minute) for mixing the existed light-curable materials 41 in the material tank 23 and the poured new light-curable materials 41 evenly and making the mixed light-curable materials 41 fill the material tank 23 evenly.

Step S22: the control module 20 determines whether a default printing condition satisfies. More specifically, above-mentioned printing condition is configured by a user or a developer in advance and stored in the memory module 29.

One of the exemplary embodiments, the printing condition may be any combination of the modeling plane having left the light-curable materials 41 for a default time (namely, the liquid level of the light-curable materials 41 has become horizontal), completion of loading the next layer of print data, or completion of pouring the new light-curable materials 41 and so on.

If the printing condition satisfies, the control module 20 performs the step S23. Otherwise, the control module 20 performs the step S22 again for continuous determination.

Step S23: the control module 20 makes the modeling plane of the curing platform 24 contact with the light-curable materials 41 in the material tank 23.

Step S24: the control module 20 controls the moving module 22 (as shown in Fig. 5, the moving module 22 may be a rotary device comprising at least one motor, gears, at least one roulette and so on) to start to rotate the material tank 23 horizontally for making the light-curable materials 41 between the curing platform 24 and the tenacity film 40 flow because of the generated centrifugal force. Thus, the downforce making the deformation area 50 of the tenacity film 40 can be released, and the tenacity film 40 reverts to become horizontal.

One of the exemplary embodiments, the moving module 22 rotates the material tank 23 with a first speed (such as 360 degrees per minute).

One of the exemplary embodiments, the first speed of the material tank 23 rotating in the step S24 is less than the second speed of the material tank 23 rotating in the step S21. More specifically, during the rotation of the step S21, because the modeling plane has left the light-curable materials 41 completely (namely, the multiple layers of printed slice physical models 42 have left the light-curable materials 41 completely), the centrifugal force generated by rotation does not damage the multiple layers of printed slice physical models 42 (such as making the multiple layers of printed slice physical models 42 be separated from the curing platform 24). Thus, the present disclosed example can mix the poured light-curable materials 41 and the light-curable materials 41 in the material tank 23 quickly via higher speed rotation. During the rotation of the step S24, because the modeling plane has contacted with the light-curable materials 41 (namely, all or part of the multiple layers of printed slice physical models 42 have submerged into the light-curable materials 41), the centrifugal force generated by rotation has possibility of damaging the multiple layers of printed slice physical models 42. Thus, the present disclosed example can prevent from damaging the multiple layers of printed slice physical models 42 via lower speed rotation.

Step S25: the control module 20 determines whether a condition of stopping moving satisfies. If the condition of stopping moving satisfies, the control module 20 performs the step S26. Otherwise, the control module 20 continues to control the moving module 22 to move the material tank 23, and determines whether the condition of stopping moving satisfies continuously.

Step S26: the control module 20 controls the moving module 22 to stop rotating the material tank 23.

Step S27: the control module 20 selects one of the multiple layers of print data (such as the first layer of print data), and controls the light module 21 to irradiate light to the curing platform 24 according to the selected layer of print data for curing the light-curable materials 41 in the light path and printing one layer of slice physical model 42 on the modeling plane.

Step S28: the control module 20 controls the curing platform 24 to move (such as lifting up) for making the modeling plane leave the light-curable materials 41.

Step S29: the control module 20 determines whether completion of 3D printing. For example, the control module 20 determines whether all of the multiple layers of the slice physical models have been printed.

If there is any layer of slice physical model do not be printed, the control module 20 performs the step S20 to the step S28 again for printing the next layer of slice physical model 42 (such as the second layer of slice physical model 42) and so on, until all of the multiple layers of slice physical models are printed, and the multiple layers of printed slice physical models stack as a 3D physical model.

The present disclosed example can effectively reduce the defects on the surface of a physical model, and improve a printing quality of the physical models.

## Claims

1. A method of making surfaces smooth or flat for 3D printing applied to a stereolithography 3D printer (2), the stereolithography 3D printer (2) comprising a light module (21), a curing platform (24), a material tank (23) and a moving module (22), a tenacity film (40) being laid on bottom of the material tank (23), the method of making surfaces smooth or flat for 3D printing comprising following steps:
a) making a modeling plane of the curing platform (24) contact with light-curable materials (41) in the material tank (23);
b) controlling the moving module (22) to start to move the material tank (23) for making the light-curable materials (41) between the curing platform (24) and the tenacity film (40) flow; and
c) stopping moving the material tank (23) and controlling the light module (21) to irradiate light to the curing platform (24) for printing one layer of slice physical model (42) on the modeling plane.

2. The method of making surfaces smooth or flat for 3D printing according to claim 1, further comprising following steps:
d1) making the modeling plane leave from the light-curable materials (41); and
d2) performing the step a) to the step d1) repeatedly until completion of printing all of the slice physical models (42), wherein the slice physical models (42) stack as a 3D physical model.

3. The method of making surfaces smooth or flat for 3D printing according to claim 2, wherein the step a) is performed to make the modeling plane contact with the stereolithography materials (41) after a printing condition satisfies.

4. The method of making surfaces smooth or flat for 3D printing according to claim 1, wherein the tenacity film (40) is made from light-transmissive silicone.

5. The method of making surfaces smooth or flat for 3D printing according to claim 1, wherein the step a) is performed to make the modeling plane contact with the light-curable materials (41) and make the modeling plane be a default thickness away from the tenacity film (40); the modeling plane is either a worktop of the curing platform (24) or the top layer of the printed slice physical model (42).

6. The method of making surfaces smooth or flat for 3D printing according to claim 1, further comprising following steps:
e1) controlling a material-providing module (26) of the stereolithography 3D printer (2) to pour the new light-curable materials (41) into the material tank (23) when a condition to supply for refilling satisfies; and
e2) controlling the moving module (22) to move the material tank (23) for making the light-curable materials (41) in the material tank (23) flow during pouring the new light-curable materials (41).

7. The method of making surfaces smooth or flat for 3D printing according to claim 6, wherein the step b) is performed to move the material tank (23) with a first speed, the step e2) is performed to move the material tank (23) with a second speed, the first speed is less than the second speed.

8. The method of making surfaces smooth or flat for 3D printing according to claim 1, wherein the step b) is performed to control the moving module (22) to move the material tank (23) in a horizontal direction back and forth or rotate the material tank (23) horizontally.

9. The method of making surfaces smooth or flat for 3D printing according to claim 1, wherein the step b) is performed to control the moving module (22) to move the material tank (23) in a horizontal direction back and forth and rotate the material tank (23) horizontally.

10. The method of making surfaces smooth or flat for 3D printing according to claim 1, wherein the step c) is performed to stop moving the material tank (23) when a condition of stopping moving satisfies.

11. The method of making surfaces smooth or flat for 3D printing according to claim 10, wherein the condition of stopping moving is moving the material tank (23) a default times, moving the material tank (23) for a default time or rotating the material tank (23) a default angle.

12. The method of making surfaces smooth or flat for 3D printing according to claim 1, wherein each layer of the print data is a 2D image, the step c) is performed to control the light module (21) to irradiate heading to a plurality of positions of the curing platform (24) corresponding to a plurality of pixels of one layer of the print data for printing one layer of the slice physical model (42) according to a plurality of pixel values of the pixels of the layer of the print data.

13. The method of making surfaces smooth or flat for 3D printing according to claim 1, wherein the step c) is performed to time a default waiting time after stopping moving the material tank (23), and control the light module (21) to irradiate heading to the curing platform (24) for printing one layer of the slice physical model (42).
